# EUROPEAN PATENT APPLICATION

(11) **EP 1 641 048 A1**
(43) Date of publication of application: **29.03.2006**
(21) Application number: 04735128.3
(22) Date of filing: 27.05.2004
(51) Int. Cl.: H01L 33/00, C09K 11/06, H01J 61/40, H01J 61/35

(54) **LIGHT-EMITTING DEVICE**

(30) Priority: 30.05.2003 JP 2003154571
(71) Applicant: MITSUBISHI CHEMICAL CORPORATION, Tokyo 108-0014 (JP)
(72) Inventor: SHIMIZU, K., c/o Mitsubishi Chem. Group Sci./Tech., Yokohama-shi, Kanagawa 227-8502 (JP); MURAYAMA, T., c/o Mitsubishi Chemical Corporation, Yokohama-shi, Kanagawa 227-8502 (JP)
(74) Representative: Vossius & Partner
(86) International application number: PCT/JP2004/007674
(87) International publication number: WO 2004/107459

(57) **Abstract**

The present invention is to provide a light emitting device which can generate light emission long in life, good in color rendering properties, wide in color reproduction range and high in intensity.

The present invention relates to a light emitting device having a light emitter which emits light within the region from near-ultraviolet light to visible light, and a fluorescent material containing at least one fluorescent complex which emits light by the action of light from the light emitter, wherein the fluorescent material is irradiated with substantially no light having a wavelength of 350 nm or less.

## Description

### Technical Field

The present invention relates to a light emitting device, and more particularly to a light emitting device in which durability of a fluorescent material is improved.

### Background Art

Light emitting devices in which light of a discharge lamp such as a mercury lamp or a semiconductor light emitting element is color converted with a fluorescent material have hitherto been used for illumination and the like. In order to generate lights of various colors such as white, in a wide color reproduction range, uniformly with a good color rendering property by mixing blue, red and green color lights, many studies have been made for these light emitting devices. Above all, light emitting devices using a semiconductor light emitter such as a light emitting diode (LED) or a semiconductor laser (LD) have high luminous efficiency and also have an advantage in terms of environmental protection such as no use of mercury. Accordingly, the development of light emitting devices in which an LED or an LD is combined with a fluorescent material has been actively carried out.

In particular, light emitting devices in which a semiconductor light emitting element such as an LED or an LD is combined with an organic red fluorescent material comprising a fluorescent complex such as a europium (Eu) complex having an anion of a β-diketone as a ligand have been reported as devices which efficiently absorbs light from near-ultraviolet light to visible light and provide high-luminance light emission, compared to a fluorescent lamp using an inorganic red fluorescent material such as Y₂O₃ : Eu (see patent document 1 and patent document 2).
Patent Document 1: JP 10-12925 A
Patent Document 2: JP 2000-509912 A

### Disclosure of the Invention

However, the europium (Eu) complex-containing red fluorescent materials as reported in patent document 1 and patent document 2 are easily suffering from photo-degradation, and it has been difficult to put a light emitting device for which durability is required into practical use. In particular, when used outdoor, there has been a problem of easy degradation by ultraviolet rays of sunlight. Further, in recent years, developments of LEDs and LDs have been directed to emission of light having a shorter wavelength. As a result, light energy becomes larger as the light from a light emitter has shorter wavelength, so that degradation of a sealing material or a fluorescent material becomes significant. It is therefore difficult to use for a long period of time. Accordingly, the necessity of improving durability has arisen.

The present invention has been made in order to solve the problem which has stood out in relief at the time of developing the light emitting device using such a fluorescent complex, particularly a rare earth ion complex such as the Eu complex. That is, an object of the present invention is to provide a light emitting device which can generate light emission long in life, good in color rendering properties, wide in color reproduction range and high in intensity.

To solve such a problem, in the light emitting device to which the present invention is applied, a fluorescent complex-containing fluorescent material is not irradiated with light having a specific wavelength. That is, the light emitting device to which the present invention is applied is characterized in that the device comprises a light emitter which emits light within the region from near-ultraviolet light to visible light, and a fluorescent material containing at least one fluorescent complex which emits light by the action of light from the light emitter, and that the fluorescent material is irradiated with substantially no light having a wavelength of 350 nm or less.

It is preferred that the light emitter in the light emitting device to which the present invention is applied is a semiconductor light emitting element, and that the fluorescent material is irradiated with substantially no light having a wavelength of 350 nm or less by providing a light absorbing means which absorbs light having a wavelength of 350 nm or less, between the semiconductor light emitting element and the fluorescent material, or by using a semiconductor light emitting element which substantially does not emit light of 350 nm or less. In this case, the semiconductor light emitting element is preferably a semiconductor light emitting element which emits light having a peak wavelength within the range of 360 nm to 470 nm.

Further, it is preferred that the fluorescent material is irradiated with substantially no light having a wavelength of 350 nm or less by providing a light absorbing means which absorbs light having a wavelength of 350 nm or less, between the light emitter and the fluorescent material. The light emitter is preferably a discharge lamp. Further, it is preferred that the fluorescent material is irradiated with substantially no light having a wavelength of 350 nm or less by providing an ultraviolet absorbing layer on the outside of the fluorescent material.

Furthermore, the fluorescent material is preferably placed under vacuum or under an atmosphere of inert gas. In addition, the light emitter and the fluorescent material are preferably sealed with a resin.

The fluorescent complex contained in the fluorescent material in the light emitting device to which the present invention is applied is preferably a rare earth ion complex. Such a rare earth ion complex is preferably a rare earth ion complex having as a ligand an anion which is derived from a β-diketone having an aromatic ring-containing substituent group or from a carboxylic acid having an aromatic ring-containing substituent group. Further, the rare earth ion complex preferably has a Lewis base as an auxiliary ligand. Moreover, the rare earth ion complex is preferably a europium complex.

In addition, the fluorescent material in the light emitting device to which the present invention is applied comprises a red fluorescent material containing a fluorescent complex, a blue fluorescent material and a green fluorescent material.

On the other hand, the present invention is grasped as a light emitting device comprising (a-1) a light-permeable container having therein a light emitter which emits light within the region from near-ultraviolet light to visible light, and a fluorescent material containing at least one fluorescent complex which emits light by the action of light from the light emitter, or (a-2) a resin-sealed body having therein a light emitter which emits light within the region from near-ultraviolet light to visible light, and a fluorescent material containing at least one fluorescent complex which emits light by the action of light from the light emitter, and (b) an ultraviolet shielding means which shields the fluorescent material from ultraviolet rays.

In this case, the ultraviolet shielding means is preferably an ultraviolet absorbing layer provided on the outside or inside of the container, or on the outside of the resin-sealed body. Such an ultraviolet absorbing layer is preferably a resin layer having incorporated therein an ultraviolet absorbing agent. Besides, the ultraviolet shielding means is preferably a container or resin-sealed body formed from a light-permeable material containing an ultraviolet absorbing agent. The ultraviolet absorbing layer in such a case is preferably one in which one kind or two or more kinds of ultraviolet absorbing agents for absorbing light having a wavelength of 400 nm or less are incorporated. Furthermore, it is preferred that a light absorbing means which absorbs light having a wavelength of 350 nm or less is further provided between the light emitter and the fluorescent material. And there can be provided a lighting system comprising the light emitting device to which the present invention is applied.

It has been known that organic compounds generally undergo a photochemical reaction by ultraviolet rays (for example, Akira Sugimoto, *Yuki Kokagaku* (Organic Photochemistry), Shokabo Publishing Co., Ltd. (1991)), and organic materials degrades by this photochemical reaction. As for this degradation, it has been known that light having a shorter wavelength causes a higher degree of degradation. Then, the degradation of europium complexes depending on the wavelength of ultraviolet light was examined with controlling the wavelength of ultraviolet light to be irradiated by ultraviolet shielding filter under various conditions. As a result, it became clear that the degradation of the organic materials is remarkable particularly in the case of light having a short wavelength of 350 nm or less.

That is, of the ultraviolet light, particularly, light having a short wavelength of 350 nm or less is largely involved in the degradation of organic materials such as ligand compounds, and the degradation hardly takes place with light having a longer wavelength than that. It is therefore extremely effective to reduce the degradation of the fluorescent material that the fluorescent complex used in the light emitting device to which the present invention is applied is provided with a means for shielding from light of substantially 350 nm or less.

Examples thereof include selection of a light source which does not emit light of substantially 350 nm or less, shielding of light of 350 nm or less emitted from a light source by an ultraviolet absorbing layer, prevention of the fluorescent material from being irradiated with ultraviolet rays from outside light by an ultraviolet absorbing layer, and the like. As a result of experiments using ultraviolet protection filters, it can be regarded from transmission spectra of the ultraviolet protection filters that substantial shielding is attained when the transmittance at 350 nm is 5% or less. The degradation by ultraviolet rays also occurs in ligand molecules, so that it is considered to be also similarly effective for other rare earth ion complexes other than the europium complex.

The means to shield the fluorescent complex used in the light emitting device to which the present invention is applied from light of substantially 350 nm or less to light from the light emitter include, for example, (1) a method of providing an ultraviolet absorbing layer containing an ultraviolet absorbing material which substantially absorbs ultraviolet light of 350 nm or less between the light emitter and the fluorescent material, thereby shielding from light of 350 nm or less from a discharge lamp such as a mercury lamp, and (2) a method of using as light source a semiconductor light emitter comprising an LED or LD which substantially does not emit light having a wavelength of 350 nm or less.

Further, as for the ultraviolet light from outside light, there is mentioned a method of providing an ultraviolet absorbing layer between the fluorescent material and outside light, thereby shielding the fluorescent material from ultraviolet rays of outside light. In this case, the ultraviolet absorbing layer is required to be arranged so that the fluorescent material is not shielded from light from the light emitter. Further, for ultraviolet light from outside light, the fluorescent material is desirable to be shielded from ultraviolet light of 400 nm or less, considering a measure against the photo-degradation of an organic compound such as a coexisting resin other than the complex.

When the LED or LD is used as the light emitter in the light emitting device to which the present invention is applied, a fluorescent material layer which is a layer of a resin composition obtained by mixing or dispersing the fluorescent complex-containing fluorescent material in a resin is formed on the upper side of the light emitter element, or the fluorescent material is mixed or dispersed in a sealing resin such as an epoxy resin that covers the LED or LD, and arranged. In the former case, the shielding from ultraviolet rays from outside light can be attained by forming the ultraviolet absorbing layer on the upper portion of the fluorescent material layer, or incorporating the ultraviolet absorbing material into the sealing resin provided on the upper portion of the fluorescent material layer. Further, in the latter case, for example, the ultraviolet absorbing layer is formed so as to cover the outside of the sealing resin body having the light emitter and the fluorescent material in the inside thereof; as shown in the second embodiment described below. In both cases, ultraviolet light from outside light in a wavelength region of 400 nm or less, which possibly degrades the fluorescent material or the resin, is shielded, and extremely sufficient light stability can be obtained.

Furthermore, in the case of a lamp type light emitting device using a light-permeable material such as glass or resin glass, protection from ultraviolet rays having a wavelength of 350 nm or less, preferably 400 nm or less, can be attained by performing ultraviolet absorption treatment such as mixing the ultraviolet absorbing agent in the light-permeable material used as a lamp container, or providing the ultraviolet absorbing layer on the outside or inside of the lamp container. In the case of the lamp type light emitting device, it becomes possible to dramatically improve light stability by evacuating the inside of the lamp or allowing the inside to be a low-oxygen concentration atmosphere by inert gas replacement. The oxygen concentration is 1000 ppm or less, preferably 100 ppm or less, and more preferably 20 ppm or less.

Thus, according to the present invention, there is provided a light emitting device which can improve the durability of a fluorescent complex-containing fluorescent material and can generate high-intensity light emission.

### Brief Description of the Drawings

Fig. 1 is a view for illustrating a light emitting device of a first embodiment.
Fig. 2 is a view for illustrating a light emitting device of a second embodiment.
Fig. 3 is a view for illustrating a light emitting device of a third embodiment.
Fig. 4 is a graph showing wavelength-transmittance behavior of ultraviolet shielding filters.
Fig. 5 is a graph showing wavelength-transmittance behavior of glass.
Fig. 6 is a graph showing a radiation spectrum of a light source of a light stability tester.

As for reference numerals in the figures, 10, 20 and 30 indicate light emitting devices, 11, 21 and 31 indicate semiconductor light emitting elements, 12 and 32 indicate fluorescent material layers, 13 and 33 indicate outside caps, 14a indicates an inert gas, 14b, 23 and 34a indicate ultraviolet absorbing layers, 15a, 15b, 25a, 25b, 35a and 35b indicate conductive wires, 16a, 26a and 36a indicate inner leads, 16b, 26b and 36b indicate mount leads, 17, 27 and 37 indicate sealing resin portions, 18, 28, 38 indicate branckets, 19, 29 and 39 indicate electric contacts, 22 indicates a fluorescent material, 24 indicates an epoxy resin portion, and 34b indicate a glass window.

### Best Mode for Carrying Out the Invention

The light emitting devices to which the present embodiments are applied are described below.

### (First Embodiment)

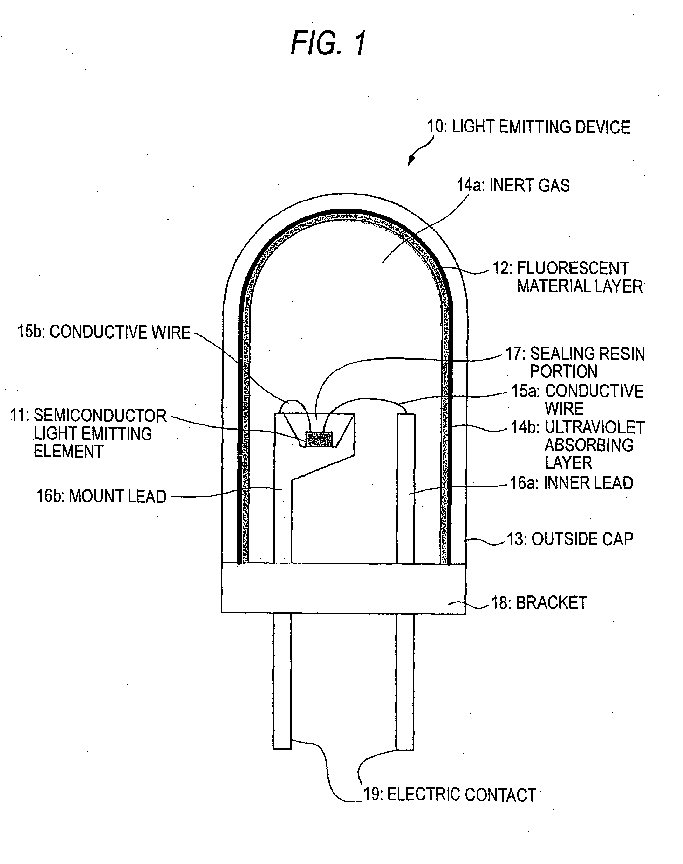

Fig. 1 is a view for illustrating the light emitting device in this embodiment. The light emitting device 10 shown in Fig. 1 comprises a brancket 18, an outside cap 13 which covers an upper portion of the brancket 18 and is formed in a dome form from, for example, a light-permeable material such as glass, a mount lead 16b and an inner lead 16a which are attached to the brancket 18, an electric contact 19 which is attached to a lower portion of the brancket 18 and conductive to the mount lead 16b and the inner lead 16a, a semiconductor light emitting element 11 housed in a cup of an upper portion of the mount lead 16b, a sealing resin portion 17 such as an epoxy resin which is filled in the cup of the upper portion of the mount lead 16b to fix the semiconductor light emitting element 11, a fluorescent material layer 12 of a layer in which a red fluorescent material is mixed and dispersed in a binder resin and which is coated on the inside of the outside cap 13, an ultraviolet absorbing layer 14b formed lying between the fluorescent material layer 12 and the outside cap 13, a conductive wire 15a which makes the inner lead 16a and the semiconductor light emitting element 11 conductive to each other, a conductive wire 15b which makes the semiconductor light emitting element 11 and the mount lead 16b conductive to each other. The inside of the outside cap 13 is in vacuum or filled with an inert gas 14a such as nitrogen gas or argon gas.

The semiconductor light emitting element 11 emits light within the region from near-ultraviolet light to visible light. This light is absorbed by the fluorescent material contained in the fluorescent material layer 12, thereby emitting visible light having a longer wavelength. The fluorescent complexes such as rare earth ion complexes used in the fluorescent materials are liable to undergo photo-degradation in the presence of oxygen, so that the inside of the outside cap 13 is filled with the inert gas 14a to remove oxygen, thereby improving light stability. Instead of filling with the inert gas 14a, it is also possible to improve light stability of the fluorescent material layer 12 to enhance durability of the light emitting device 10 by keeping the inside of the outside cap in a vacuum state. Oxygen is preferably removed so that the oxygen concentration in the inside of the outside cap 13 becomes 100 ppm or less, and preferably 20 ppm or less. Under such an atmosphere, light stability of the fluorescent complex is significantly improved. Further, light stability is also improved under low humidity.

As the semiconductor light emitting element 11 which emits light within the region from near-ultraviolet light to visible light, there is used a semiconductor laser (LD), a light emitting diode (LED) or the like. The semiconductor light emitting element 11 having a peak wavelength at an excessively short wavelength side has the tendency that organic compounds such as the complex and the binder resin are liable to degrade. This is therefore unfavorable. Further, when the peak wavelength is at an excessively long wavelength side, light excitation energy necessary for light emission of the fluorescent complex is not obtained, so that the fluorescent material can not emit light. From the above-mentioned reasons, the light emission peak wavelength of the semiconductor light emitting element 11 is preferably within the range of 360 nm to 470 nm, and particularly, the LD or LED having a peak wavelength of 380 nm to 470 nm is preferred.

The fluorescent material layer 12 is provided in a film form formed by applying the resin composition comprising the fluorescent complex and the binder resin onto the inside of the outside cap 13. Although the fluorescent complex is not particularly limited, a rare earth ion complex which is a complex of one kind or two or more kinds of ligand anions and a trivalent rare earth element ion is generally used. The rare earth elements include Sm, Eu, Tb, Ey, Tm and the like. Above all, the ion complexes of the Eu (europium) element, the Tm (thulium) element and the Tb (terbium) element are preferred as a red fluorescent material, a blue fluorescent material and a green fluorescent material, respectively. In the fluorescent complex 12, it is also possible to properly use an inorganic fluorescent material together, in addition to the above-mentioned rare earth ion complexes.

Of the rare earth ion complexes, the europium complex is particularly preferred as the red fluorescent material which emits high-luminance light on ultraviolet light irradiation, which is hard with an inorganic fluorescent material. Further, the rare earth ion complex is preferably a complex having as a ligand an anion of a β-diketone having an aromatic ring-containing substituent group or a carboxylic acid ion having an aromatic group-containing substituent group.

The complexes having an anion of a β-diketone having an aromatic ring-containing substituent group as a ligand include, for example, a europium complex represented by any one formula of the following general formulas (1), (2) and (3).

(R₁)₃Eu (1)

(R₁)₃Eu(R₂)₂ (2)

[(R₁)₄Eu] ⁻R₃⁺ (3)

In formulas (1), (2) and (3), R₁ is an anion of a β-diketone having an aromatic ring-containing substituent group, R₂ is an auxiliary ligand comprising a Lewis base, and R₃⁺ is a quaternary ammonium ion.

It is preferred that the β-diketone having an aromatic ring-containing substituent group has at least one aromatic group, and further, the aromatic groups include an aromatic hydrocarbon compound or aromatic heterocyclic compound each optionally having a substituent group. The aromatic hydrocarbon compounds include, for example, benzene, naphthalene, phenanthrene and the like. The aromatic heterocyclic compound include oxygen, nitrogen, sulfur atom-containing heterocyclic compounds such as furan, thiophene, pyrazoline, pyridine, carbazole, dibenzofuran and dibenzothiophene.

Besides, the substituent groups of these aromatic hydrocarbon compounds or aromatic heterocyclic compounds include, for example, an alkyl group such as methyl, ethyl, propyl or butyl; a fluoroalkyl group such as trifluoromethyl or pentafluoroethyl; an alkoxy group such as methoxy or ethoxy; an aryloxy group such as benzyl or phenethyl; a hydroxyl group; an allyl group; an acyl group such as acetyl or propionyl; an acyloxy group such as acetoxy, propionyloxy or benzoyloxy; an alkoxycarbonyl group such as methoxycarbonyl or ethoxycarbonyl; an aryloxycarbonyl group such as phenoxycarbonyl; a carboxyl group; a carbamoyl group; an amino group; a substituted amino group such as dimethylamino, diethylamino, methylbenzylamino, diphenylamino or acetylmethylamino; a substituted thio group such as methylthio, ethylthio, phenylthio or benzylthio; a mercapto group; a substituted sulfonyl group such as ethylsulfonyl or phenylsulfonyl; a cyano group; a halogen group such as fluoro, chloro, bromo or iodo; and the like. These substituent groups may combine with each other to form a ring.

The substituent groups other than the aromatic groups which constitute the β-diketones include the same substituent groups (with the exception of halogen groups) as those of the above-mentioned aromatic hydrocarbon compounds or aromatic heterocyclic compounds. Specific examples (1 to 19) of the β-diketones having the aromatic ring-containing substituent group are shown below, but are not limited thereto in this embodiment.

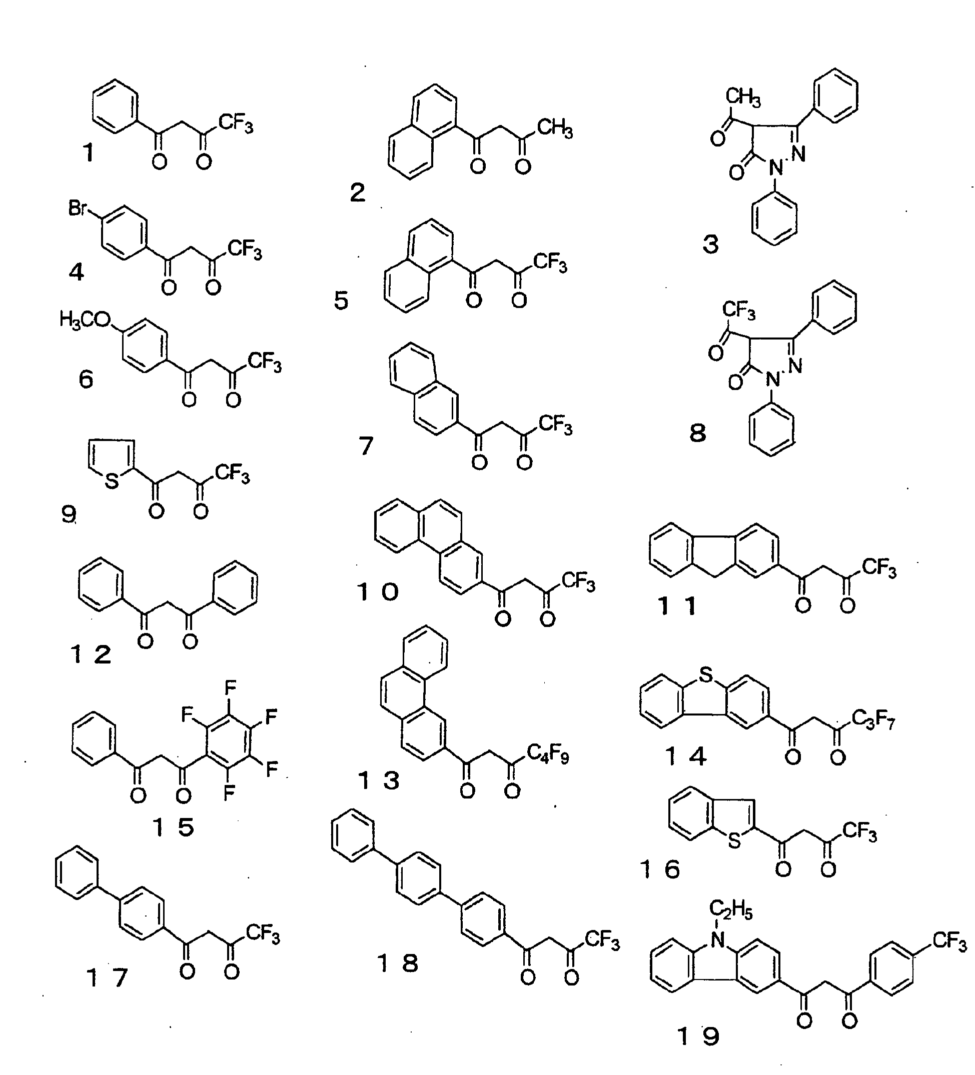

Specific examples (1 to 7) of the europium complexes represented by general formula (1) are shown below, but are not limited thereto in this embodiment.

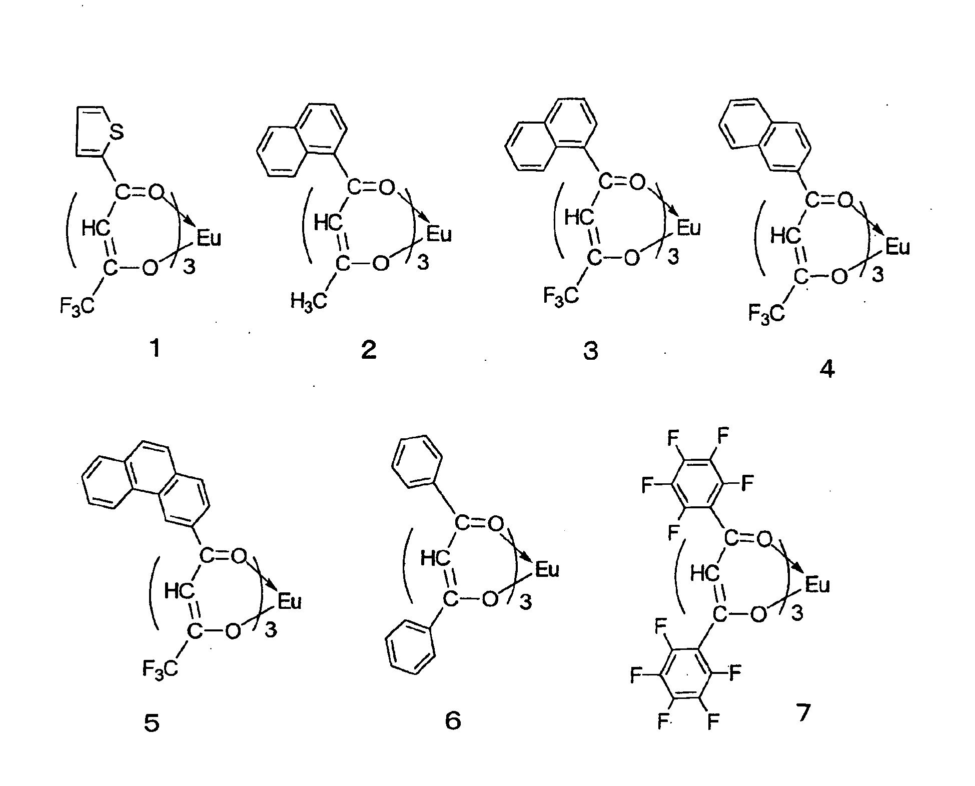

Then, the europium complex represented by general formula (2) is described. Although the auxiliary ligand (R₂) comprising the Lewis base in general formula (2) is not particularly limited, it is usually selected from Lewis base compounds having a nitrogen atom or an oxygen atom which can coordinate to the europium ion. Examples thereof include an amine, an amine oxide, a phosphine oxide and a sulfoxide, each optionally having a substituent group, and the like. The two Lewis base compounds used as the auxiliary ligand may be compounds different from each other, or two compounds may form one compound.

Specifically, for example, the amines include pyridine, pyrazine, quinoline, isoquinoline, phenanthridine, 2,2'-bipyridine, 1,10-phenanthroline and the like. The amine oxides include N-oxides of the above-mentioned amines such as pyridine-N-oxide and 2,2'-bipyridine-N,N'-dioxide. The phosphine oxides include triphenylphosphine oxide, trimethylphosphine oxide, trioctylphosphine oxide and the like. The sulfoxides include diphenyl sulfoxide, dioctyl sulfoxide and the like. As the substituent groups to be substituted to these, there are exemplified the substituent groups described above. Above all, particularly preferred are an alkyl group, an aryl group, an alkoxyl group, an aralkyl group, an aryloxy group, a halogen group and the like.

Of these Lewis base compounds, when there exist two coordinated atoms in a molecule, for example, two nitrogen atoms or the like, such as bipyridine and phenanthroline, one Lewis base compound may be allowed to act as two auxiliary ligands. As the substituent groups to be substituted to these Lewis base compounds, there are exemplified the substituent groups described above. Above all, particularly preferred are an alkyl group, an aryl group, an alkoxyl group, an aralkyl group, an aryloxy group, a halogen group and the like.

Specific examples (1 to 23) of the Lewis base compounds (R₂) used as the auxiliary ligand are exemplified below. However, the Lewis base compounds used in this embodiment should not be construed as being limited thereto.

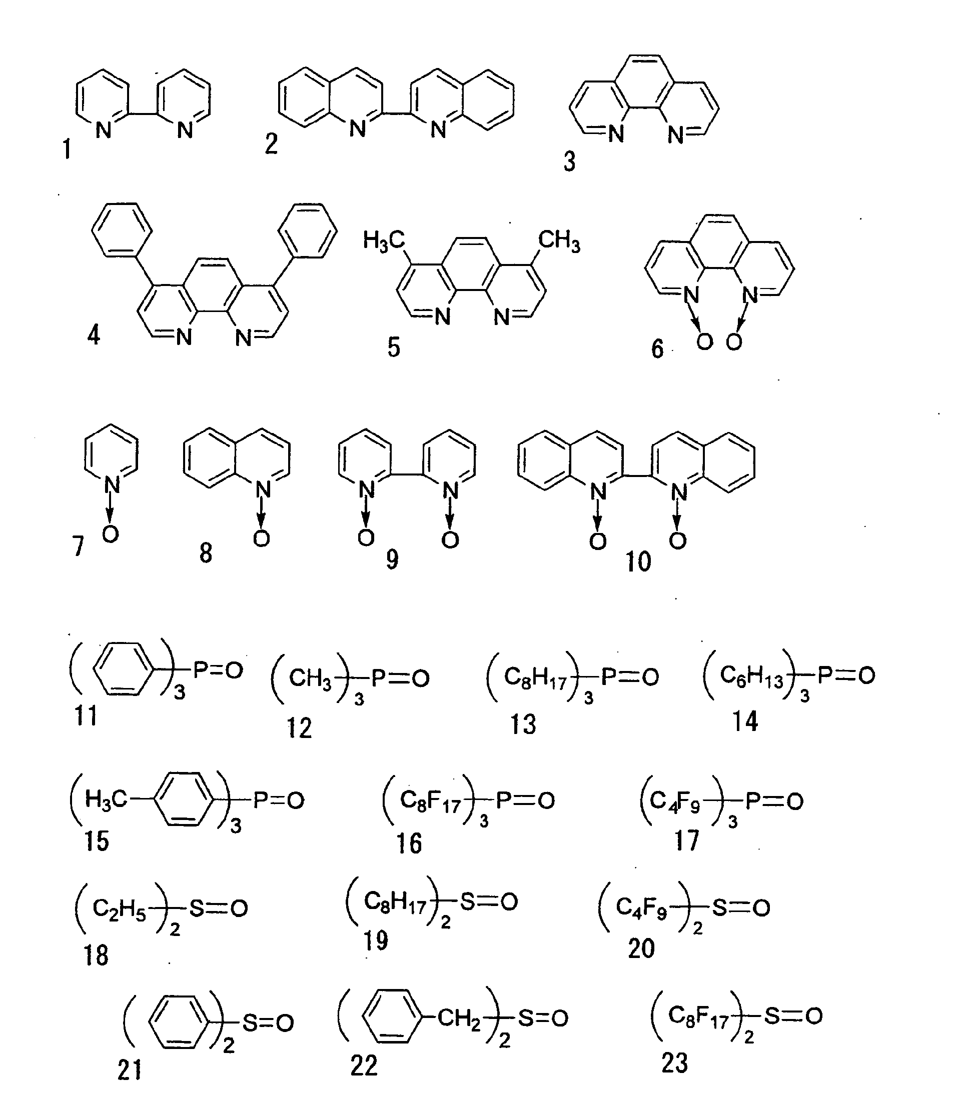

Specific examples (1 to 13) of the europium complexes represented by general formula (2) are shown below, but are not limited thereto in this embodiment.

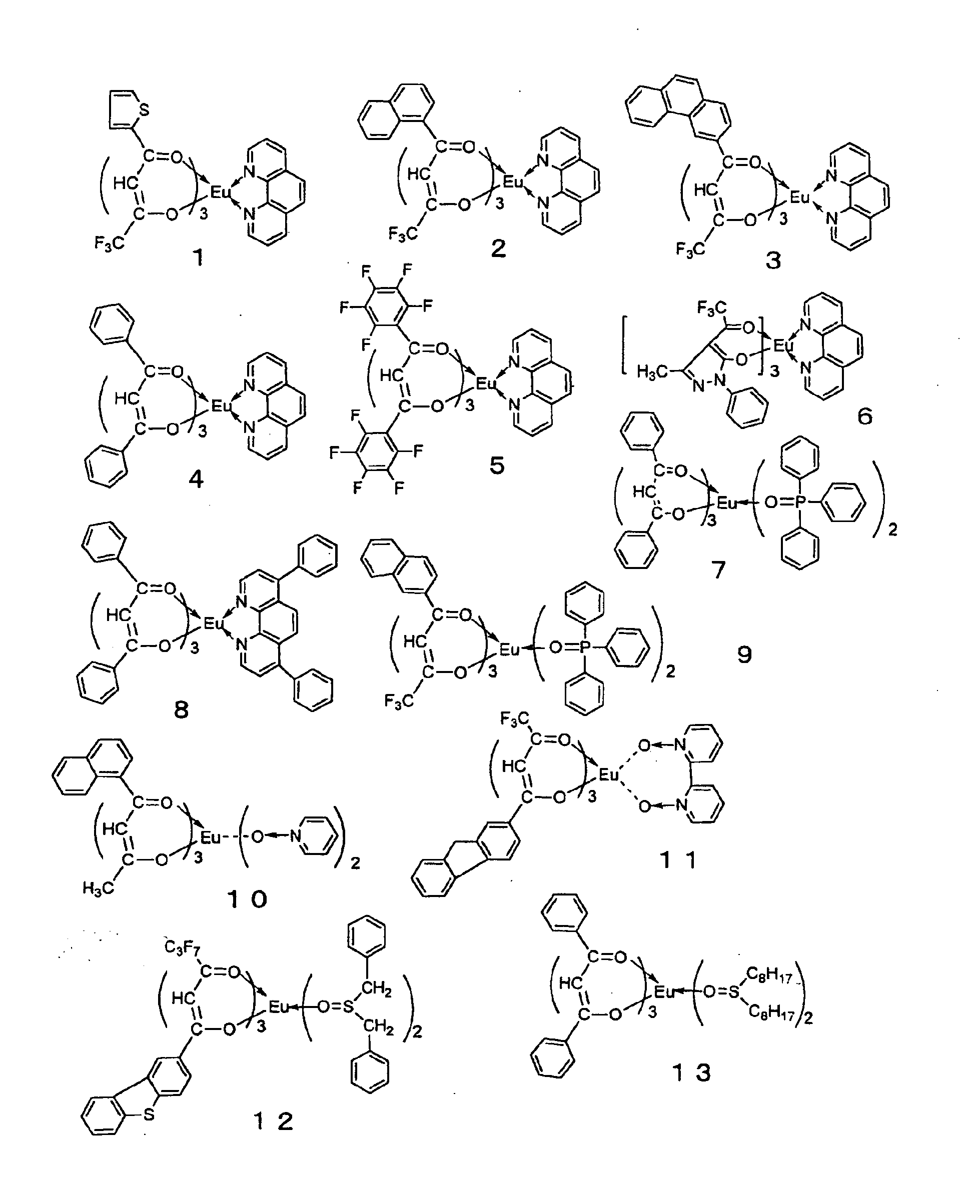

The europium complex represented by general formula (3) is described below.

The ammonium ions in general formula (3) include and a quaternary ammonium salt derived from an alkylamine, an arylamine or an aralkyl ion. The substituent groups of the amine include an alkyl group such as methyl, ethyl, propyl, butyl, hexyl or octyl; a substituted alkyl group such as hydroxyethyl or methoxyethyl; an aryl group such as phenyl or tolyl; an arylalkyl group such as benzyl or phenethyl; and the like.

Specific examples (1 to 5) of the europium complexes represented by general formula (3) are shown below, but are not limited thereto in this embodiment.

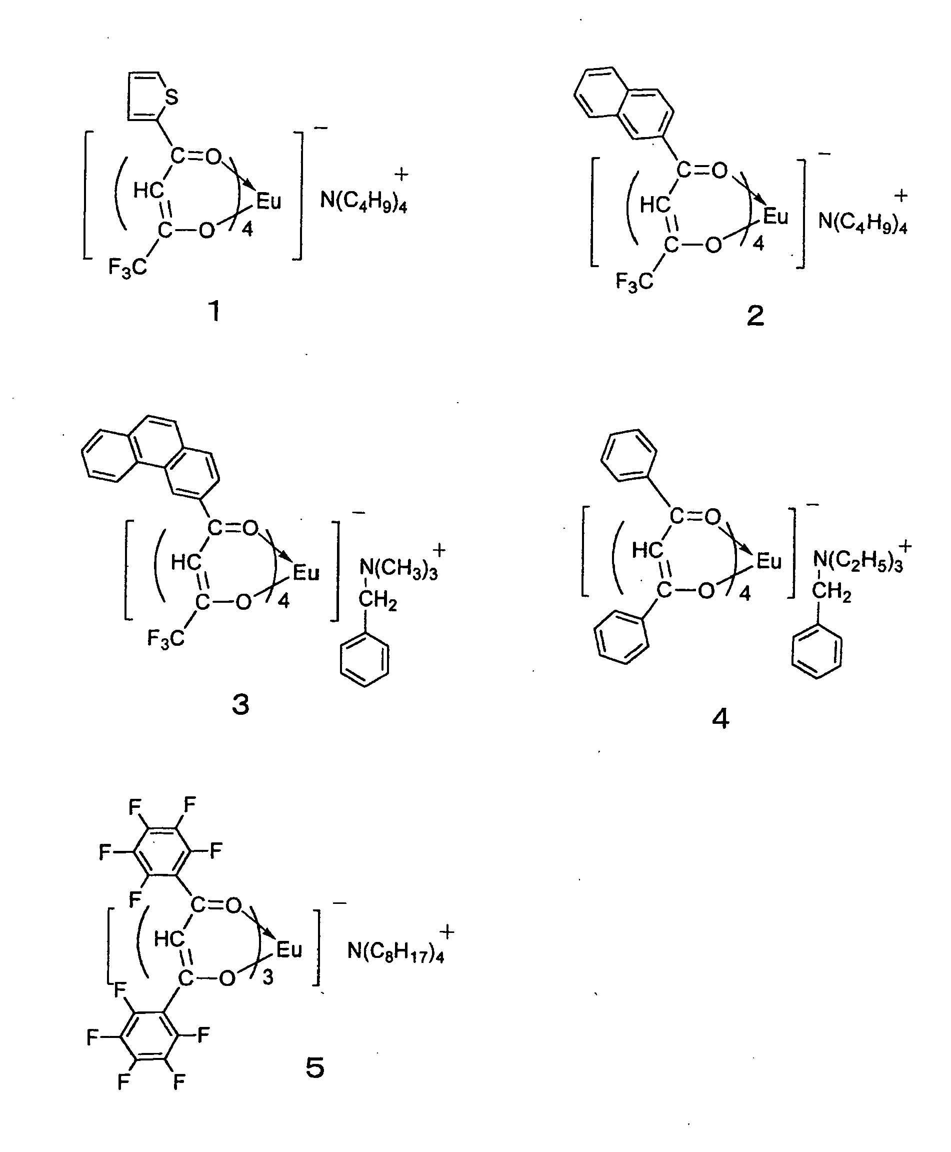

The complex having as a ligand a carboxylic acid ion having an aromatic group-containing substituent group, which is an alternative compound of the rare earth ion complex, includes, for example, a europium complex represented by the following general formula (4):

(R₄-(X)ₙ-COO)₃Eu(R₅)₂ (4)

wherein R₄ is a group containing at least one aromatic hydrocarbon ring or aromatic heterocycle each optionally having a substituent group, X is a divalent connecting group, n is 0 or 1, and R₅ is an auxiliary ligand comprising a Lewis base.

In terms of the absorption wavelength region, it is preferred that a carboxylic acid ion which contains at least one aromatic ring, which has 8 or more π electrons and which constitutes a π-electron conjugated system is used as a ligand represented by general formula (4). Further, the number of the aromatic rings is not particularly limited as long as the triplet energy of a mother compound of the carboxylic acid ion is higher than the excited-state energy level of the europium ion. However, it is usually preferred to use a tricyclic or less cyclic aromatic ring or aromatic heterocycle. When the number of aromatic rings is 4 or more, for example, in a compound having four aromatic rings such as pyrene, the triplet energy excited by absorbing light from the semiconductor light emitting element 11 decreases, so that there is the possibility that the rare earth element ion complex becomes impossible to emit light.

R₄ in general formula (4) is preferably a monovalent group derived from a tricyclic or less cyclic aromatic hydrocarbon ring optionally having a substituent group or from a tricyclic or less cyclic heterocyclic aromatic ring optionally having a substituent group. The aromatic rings include, for example, aromatic monocyclic hydrocarbons or aromatic condensed polycyclic hydrocarbons such as benzene, naphthalene, indene, biphenylene, acenaphthene, fluorene, phenanthrene, tetralin, indan and indene; compounds derived from aromatic hydrocarbons such as benzoquinone, naphthoquinone and anthraquinone; and the like. The heterocyclic aromatic rings include aromatic monocyclic heterocycles or aromatic condensed polycyclic heterocycles such as furan, pyrrole, thiophene, oxazole, isoxazole, thiazole, imidazole, pyridine, benzofuran, benzothiophene, coumarin, benzopyran, carbazole, xanthene, quinoline and triazine; and the like.

Further, the substituent groups which R4 may have include an alkyl group such as methyl, ethyl, propyl or butyl; a fluoroalkyl group such as trifluoromethyl or pentafluoroethyl; a cycloalkyl group such as cyclohexyl; an ethynyl group; an arylethynyl group such as phenylethynyl, pyridylethynyl or thienylethylyl; an alkoxy group such as methoxy or ethoxy; an aryl group such as phenyl or naphthyl; an aralkyl group such as benzyl or phenethyl; an aryloxy group such as phenoxy, naphthoxy or biphenyloxy; a hydroxyl group; an allyl group; an acyl group such as acetyl, propionyl, benzoyl, toluoyl or biphenylcarbonyl; an acyloxy group such as acetoxy, propionyloxy or benzoyloxy; an alkoxycarbonyl group such as methoxycarbonyl or ethoxycarbonyl; an aryloxycarbonyl group such as phenoxycarbonyl; a carboxyl group; a carbamoyl group; an amino group; a substituted amino group such as dimethylamino, diethylamino, methylbenzylamino, diphenylamino or acetylmethylamino; a substituted thio group such as methylthio, ethylthio, phenylthio or benzylthio; a mercapto group; a substituted sulfonyl group such as ethylsulfonyl or phenylsulfonyl; a cyano group; a halogen group such as fluoro, chloro, bromo or iodo; and the like. Of these, preferred are an alkyl group, an alkoxy group, an aryl group, a cycloalkyl group, a cycloalkyl group, an aryloxy group, aralkyl group, an ethynyl group and a halogen group. R4 is not limited to these substituent groups. Besides, these substituent groups may further have a substituent group in some cases.

Then, the carboxylic acid ion in general formula (4) is divided into the case of having no X as a divalent connecting group (n=0) and the case of having X (n=1). Further, in the case of having X as a divalent connecting group (n=1), X is divided into two types of forms, the case of having a carbonyl group and the case having no carbonyl group. Accordingly, the carbonyl ion in general formula (4) is further represented by general formula (5) shown below having no carbonyl group and general formula (6) having a carbonyl group. In the europium complex, any of complex structures having these carboxylic acid ions as ligands can be used.

R₄―R₆―COO⁻ (5)

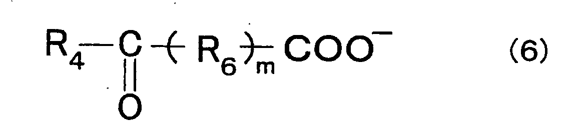

In general formula (5) and general formula (6), R₆ may be any as long as it acts as a divalent connecting group. Examples thereof include an alkylene group, a divalent connecting group derived from a ring-assembled hydrocarbon, a divalent connecting group derived from an aliphatic ring, an aromatic ring or a heterocycle, and the like. Further, in general formula (6), m is 0 or 1. The alkylene groups of R₆ include methylene, ethylene and the like. The ring-assembled hydrocarbons include biphenyl, terphenyl, binaphthyl, cyclohexylbenzene, phenylnaphthalene and the like. The aliphatic rings include cyclopentane, cyclohexane, cycloheptane, norbornane, bicyclohexyl and the like. The aromatic rings include the same compounds as the specific examples of the aromatic rings described above. The heterocycles include, as well as the aromatic heterocycles described above, aliphatic heterocycles such as pyrazoline, piperazine, imidazolidine and morpholine. In addition, R₆ includes a thioalkylene such as -SCH₂; an oxyalkylene such as -OCH₂- or -OCH₂CH₂-; vinylene (-C=C-); and the like. R₆ is not limited to these divalent substituent groups. These divalent substituent groups may further have a substituent group in some cases.

Specific examples of the carboxylic acids from which the carboxylic acid ion in general formula (4) is derived are exemplified below. The carboxylic acid used in this embodiment is not limited thereto. In general formula (4), when n is 0, the compounds include the following carboxylic acids (1 to 10):

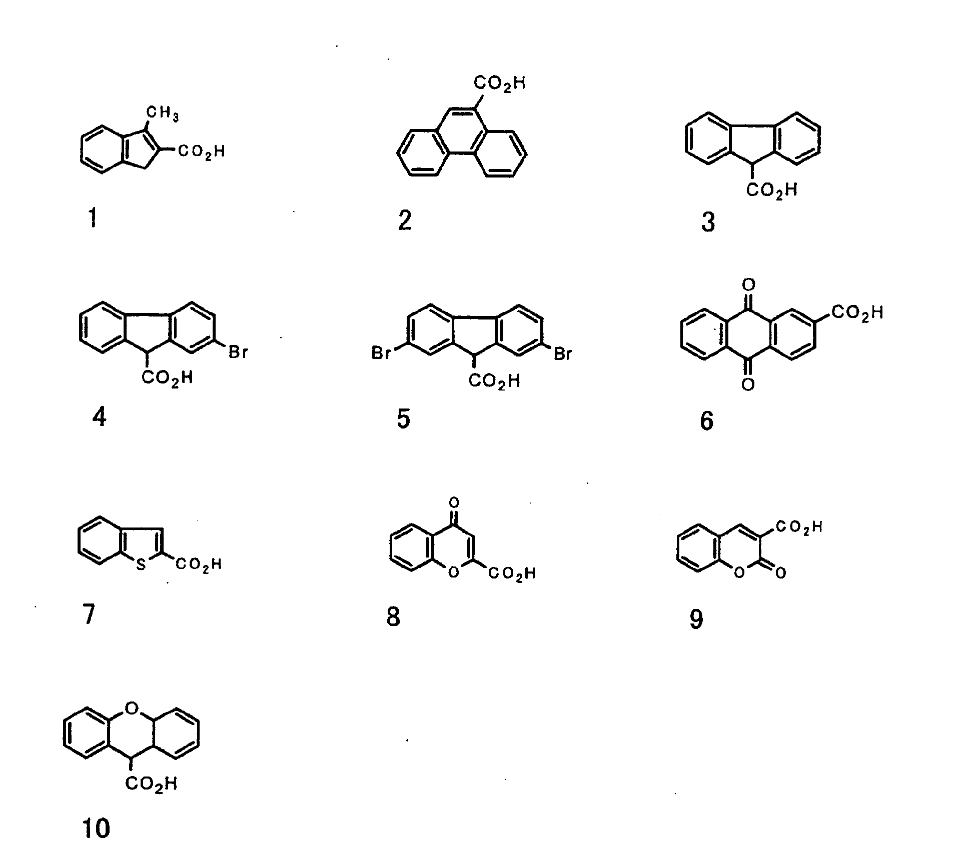

Next, in general formula (4), when n is 1 and X is R₆ (general formula (5)), then the compounds include the following carboxylic acids (11 to 15):

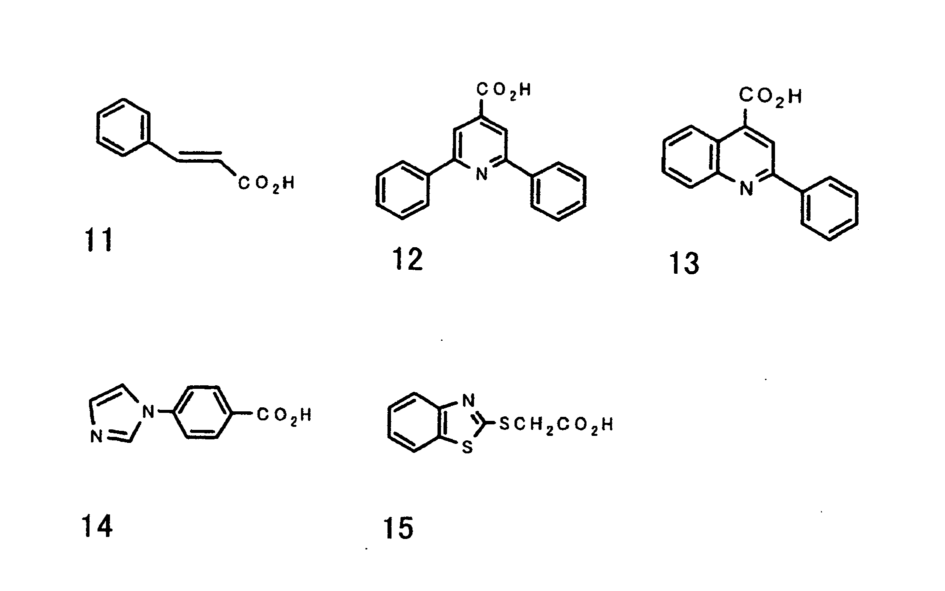

Then, in general formula (6), when m is 0, the compounds include the following carboxylic acids (16 and 17) :

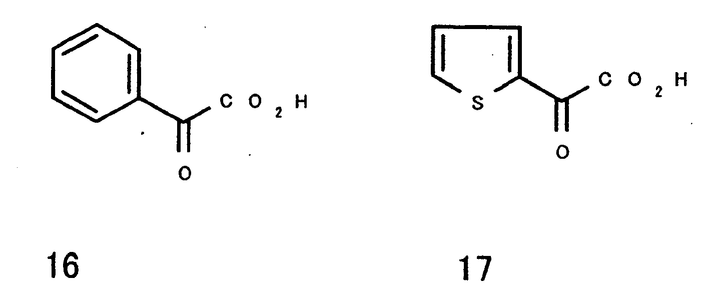

In general formula (6), when m is 1, R₄ is a phenyl group and R₆ is a phenylene group, then the compounds include the following carboxylic acids (18 to 30):

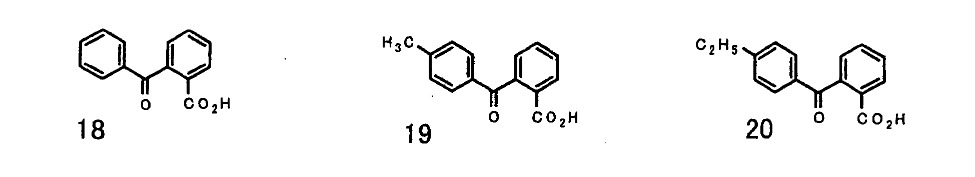

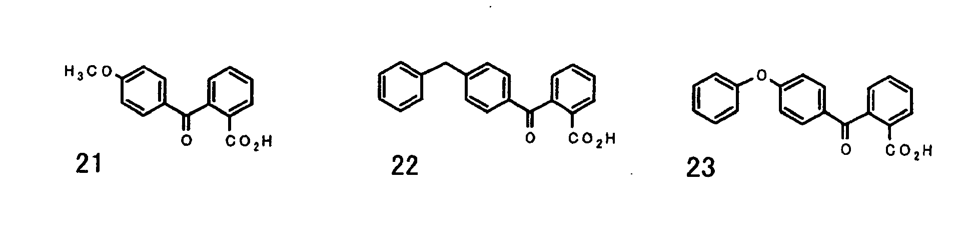

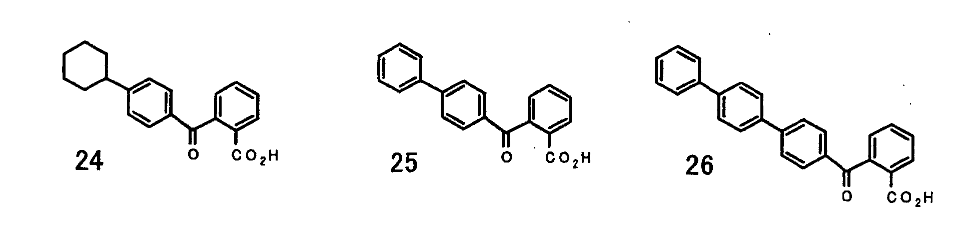

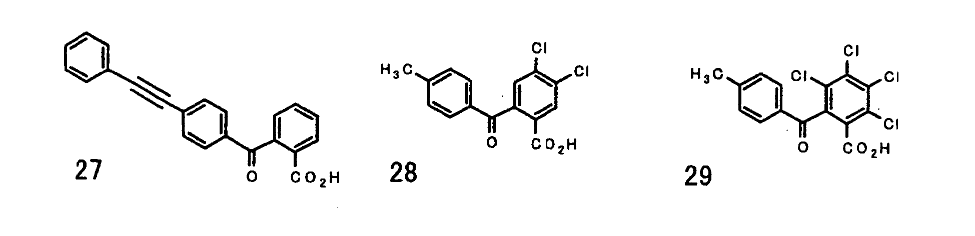

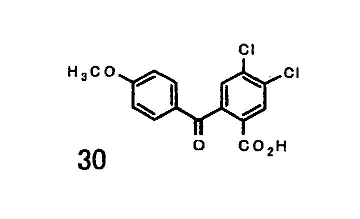

In general formula (6), when m is 1, R₄ is a phenyl group and R₆ is a naphthylene group, then the compounds include the following carboxylic acids (31 to 34):

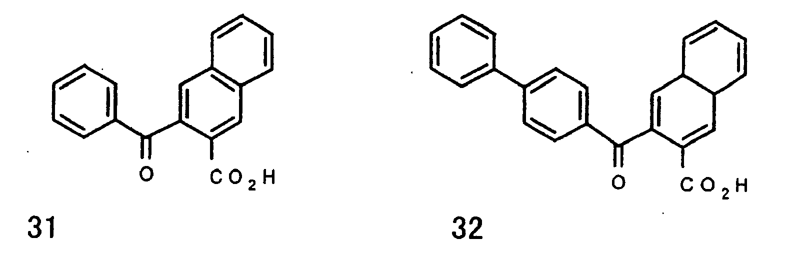

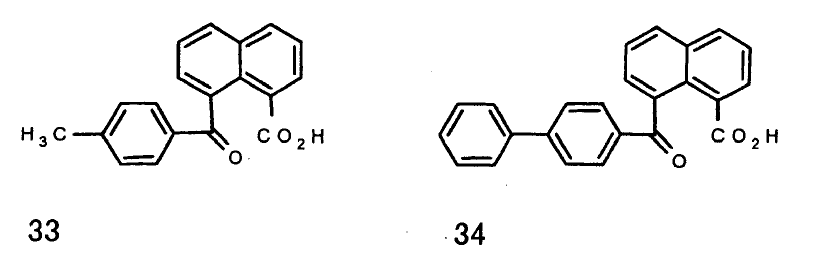

In general formula (6), when m is 1, R₄ is a phenyl group and R₆ is another group, then the compounds include the following carboxylic acids (35 to 37):

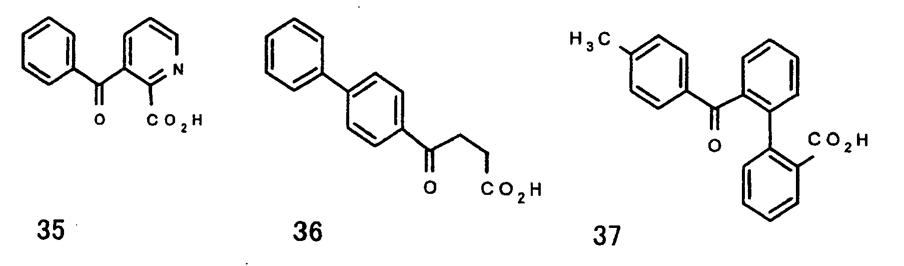

In general formula (6), when m is 1, R₄ is a naphthyl group and R₆ is an aromatic hydrocarbon ring, then the compounds include the following carboxylic acids (38 to 41):

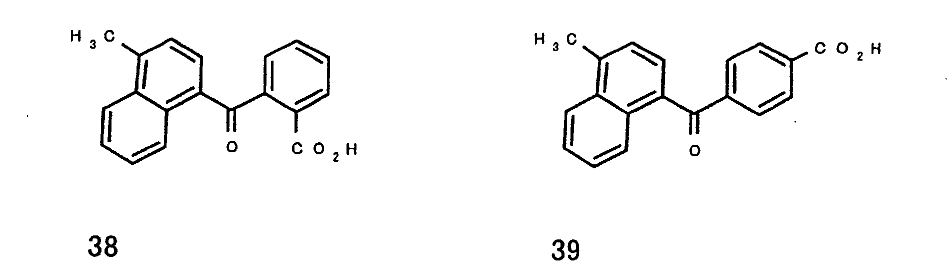

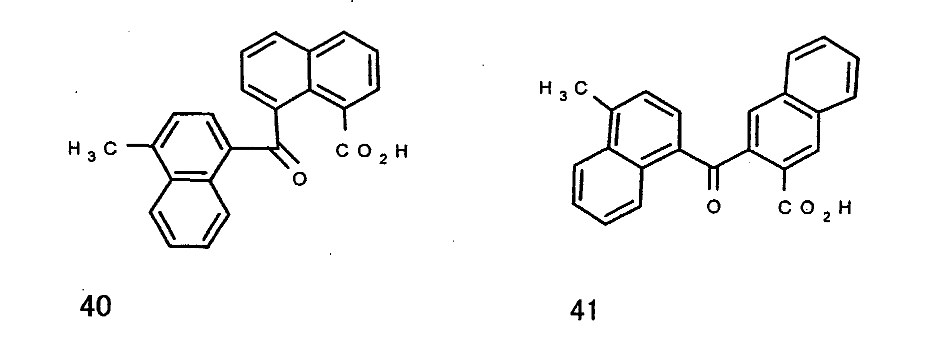

In general formula (6), when m is 1, R₄ is a naphthyl group and R₆ is another group, then the compounds include the following carboxylic acids (42 to 44):

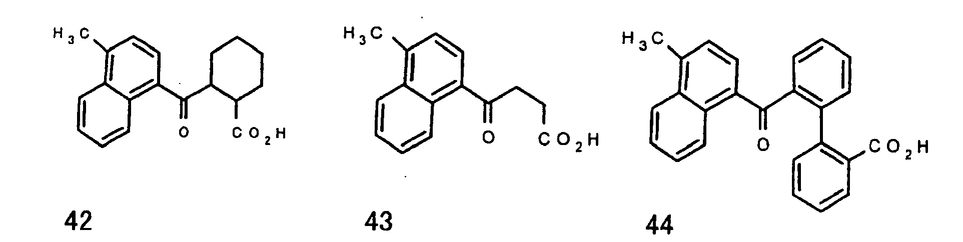

In general formula (6), when m is 1, R₄ is an acenaphthyl group and R₆ is a phenylene group or another group, then the compounds include the following carboxylic acids (45 to 48):

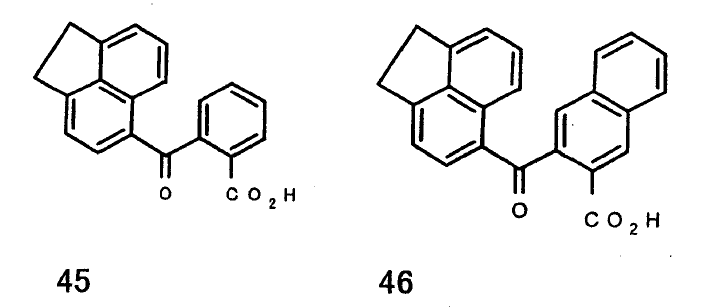

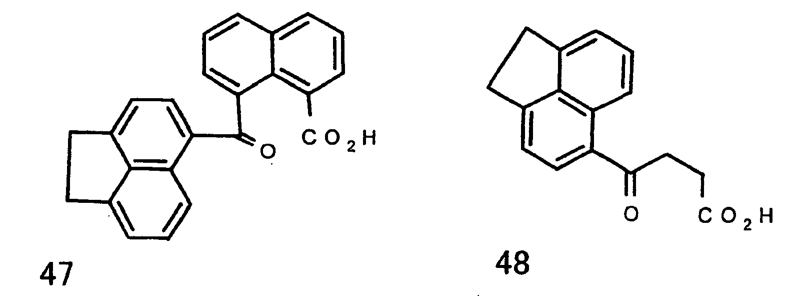

In general formula (6), when m is 1, R₄ is a fluorenyl group and R₆ is a phenylene group, then the compounds include the following carboxylic acids (49 to 55):

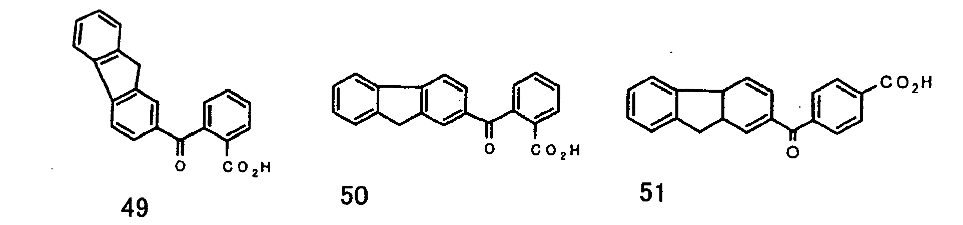

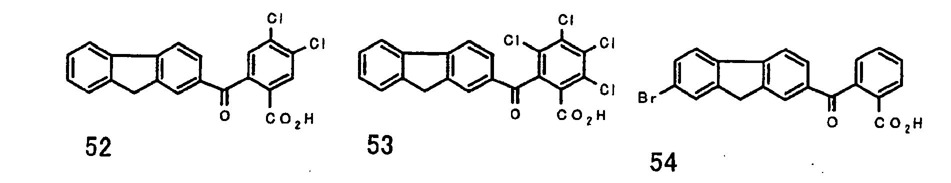

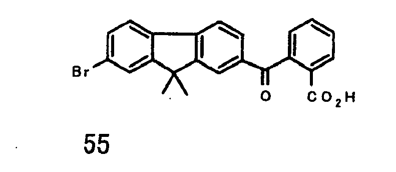

In general formula (6), when m is 1, R₄ is a phenanthrenyl group and R₆ is a phenylene group or another group, then the compounds include the following carboxylic acids (56 to 59):

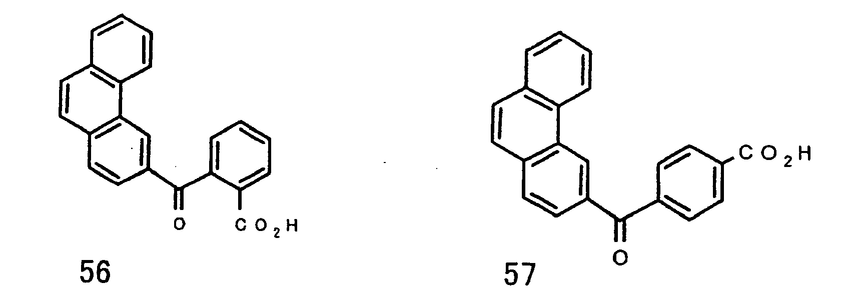

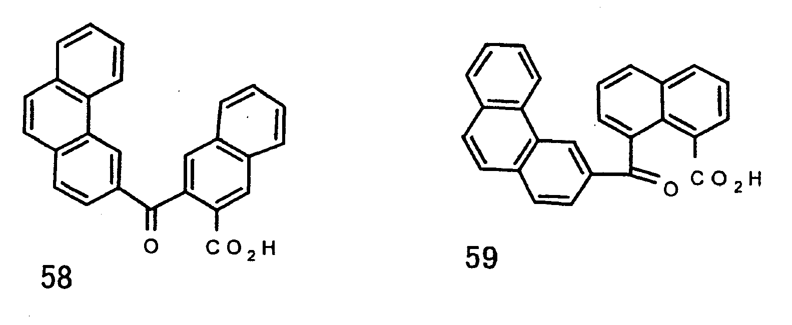

In general formula (6), when m is 1, R₄ is a heterocyclic group and R₆ is a phenylene group, then the compounds include the following carboxylic acids (60 and 61) :

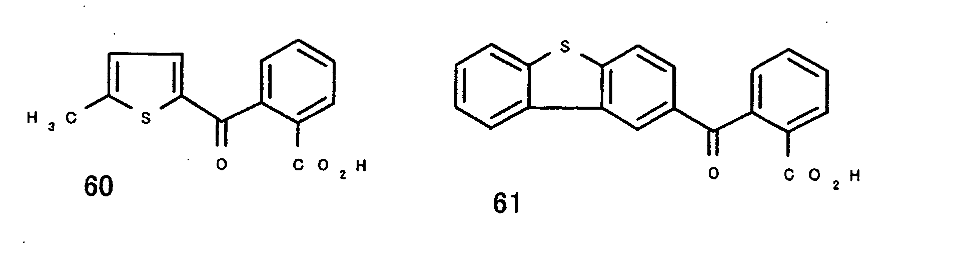

The carboxylic acid from which the carboxylic acid ion as the ligand in general formula (4) is derived can be synthesized by known methods. Synthesis methods are described, for example, in *Shin-Jikken Kagaku Koza* (New Course for Experimental Chemistry), Vol. 14, "Synthesis and Reaction of Organic Compounds (II)", page 921, edited by The Chemical Society of Japan (1977), *Jikken Kagaku* Koza (Course for Experimental Chemistry), 4th Ed., Vol. 22, "Organic Synthesis", page 1, edited by The Chemical Society of Japan (1992) or the like. Typical examples of the synthesis methods include an oxidation reaction of a corresponding primary alcohol or aldehyde, a hydrolysis reaction of an ester or a nitrile, a Friedel-Craft reaction by an acid anhydride, and the like.

In particular, according to the Friedel-Craft reaction using phthalic anhydride, naphthalic anhydride, succinic anhydride, diphenic anhydride, 1,2-cyclohexanedicarboxylic acid anhydride, 2,3-pyridazinecarboxylic acid anhydride or the like, a carboxylic acid having a carbonyl group in its molecule can be synthesized. For example, according to the Friedel-Craft reaction using an aromatic hydrocarbon or an aromatic heterocycle and phthalic anhydride, a carboxylic acid in which a carbonyl group is bonded to the ortho-position of a benzene ring can be easily synthesized, as shown in the reaction formula shown below. The carboxylic acid in which a carbonyl group is bonded to the ortho-position of a benzene ring is preferred, because a complex having high luminance is easily obtained compared to the para-substituted one. In the formula, Ar represents an aromatic hydrocarbon or an aromatic heterocycle.

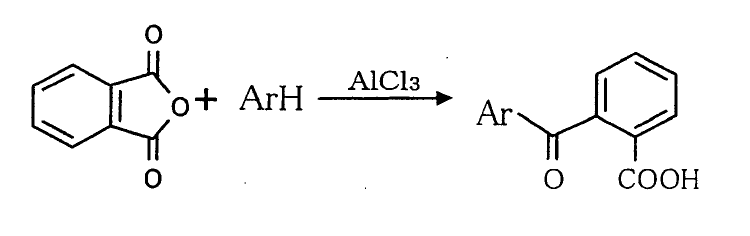

The auxiliary ligand (R₅) comprising the Lewis base in general formula (4) includes the compound as the auxiliary ligand (R₂) comprising the Lewis base in general formula (2) described above.

In the light emitting device 10 to which this embodiment is applied, the fluorescent material layer 12 is prepared, for example, as a resin composition obtained by mixing or dispersing the europium complex, and optionally another rare earth ion complex and an inorganic fluorescent material, for example, in the case of white light, a mixture of another blue fluorescent material and a green fluorescent material as described below, in an appropriate binder resin, and disposed by coating or other methods at a position where light from the semiconductor light emitting element 11 is absorbed, such as an inner wall of the outside cap 13. The binder resins include a thermoplastic resin, a thermosetting resin, a photo-curing resin and the like. Specific examples thereof include a methacrylic resin such as polymethyl methacrylate; a styrenic resin such as polystyrene or a styreneacrylonitrile copolymer; a polycarbonate resin; a polyester resin; a phenoxy resin; a butyral resin; polyvinyl alcohol; a cellulosic resin such as ethyl cellulose, cellulose acetate or cellulose acetate butyrate; an epoxy resin; a phenol resin; a silicone resin; and the like.

In the light emitting device 10 to which this embodiment is applied, the inside of the glass outside cap 13 is coated with the ultraviolet absorbing layer 14b containing the ultraviolet absorbing agent to provide a means which shield ultraviolet light supplied from outside light. Although the ultraviolet absorbing agent contained in the ultraviolet absorbing layer 14b is not particularly limited, there are exemplified, for example, a benzophenone-based agent such as o-hydroxybenzophenone, 2-hydroxy-4-n-octoxybenzophenone or 2-hydroxy-4-methoxybenzophenone; a benzotriazole-based agent such as 2-(2'-hydroxyphenyl)benzotriazole, 2-(2'-hydroxy-5'-t-octylphenyl)benzotriazole, 2-(2'-hydroxy-3'-t-butyl-5'-methylphenyl)-5-chlorobenzotriazole or 2-(2'-hydroxy-5'-methylphenyl)benzotriazole; a cyanoacrylate-based agent such as ethyl-2-cyano-3,3-diphenylacrylate or 5-ethylhexyl-2-cyano-3,3-diphenylacrylate; salicylic acid-based agent such as phenyl salicylate or 4-t-butylphenyl salicylate; a oxalanilide-based agent such as 2-ethyl-5'-t-butyl-2'-ethoxy-N,N'-diphenyloxalanilide; an inorganic compound-based agent such as zinc oxide, titanium oxide or zirconium oxide; and the like. These inorganic compounds may be contained in glass to be used as ultraviolet shielding glass.

The organic ultraviolet absorbing agent can be used by dissolving it in a resin, so that it has good transparency. Further, the inorganic ultraviolet absorbing agent can provide the ultraviolet absorbing layer having excellent transparency by using dispersed particles having an average particle size of 100 nm or less. Furthermore, for a photoactive compound such as titanium oxide, particle surfaces are preferably treated with an inert material such as silica. The ultraviolet shielding effect of these ultraviolet absorbing agents can be adjusted by controlling the amount thereof added. Above all, the ultraviolet absorbing agents for shielding ultraviolet rays of 350 nm or less include a benzophenone-based agent, zinc oxide and the like. They may be used either singly or as a combination of two or more thereof. The use of these ultraviolet absorbing agents can substantially shield light having a wavelength of 350 nm or less. Further, in order to prevent degradation of organic compounds such as the binder resin to improve durability of the light emitting device, it is preferred to shield near-ultraviolet light having a wavelength of 400 nm or less. This is achieved by appropriate selection from the above-mentioned ultraviolet absorbing agents.

The ultraviolet absorbing agent is ordinarily used by mixing it with a proper resin. The resins used include a thermoplastic resin, a thermosetting resin, a photo-curing resin and the like. Specific examples thereof include a acrylic resin such as polymethyl methacrylate; a styrenic resin such as polystyrene or a styreneacrylonitrile copolymer; a polycarbonate resin; a polyester resin; a phenoxy resin; a butyral resin; polyvinyl alcohol; a cellulosic resin such as ethyl cellulose, cellulose acetate or cellulose acetate butyrate; an epoxy resin; a phenol resin; a silicone resin; and the like. Above all, in terms of transparency, heat resistance and light stability, preferred are an epoxy resin, a butyral resin, polyvinyl alcohol and the like.

The light emitting device 10 to which this embodiment is applied further has a blue fluorescent material and a green fluorescent material, together with the red fluorescent material containing the rare earth ion complex such as the europium complex, and a combination of these makes it possible to emit white light. As the blue fluorescent material or the green fluorescent material, there can be used a known fluorescent material. For example, the blue fluorescent materials include an inorganic fluorescent material such as ZnS:Ag, Sr₅(PO₄)₃Cl:Eu or BaMgAl₁₀O₁₇:Eu. Further, the green fluorescent materials include an inorganic fluorescent material such as ZnS:Cu, ZnS:CuAl, BaMgAl₁₀O₁₇:EU or Mn. In addition, the blue fluorescent materials include a thulium complex, and the green fluorescent materials include an organic fluorescent material such as a terbium complex. As the ligands of these complexes, there can be used aromatic group-containing carboxylic acid ions used as the ligands of the europium complexes in this embodiment, as well as the known ligands. In order to emit white light by using these fluorescent materials, a fluorescent material resin layer containing a mixture of these fluorescent materials is used as the fluorescent material layer 12. Further, the resin layer of these fluorescent materials may be arranged on the semiconductor light emitting element 11. Furthermore, only a resin layer containing the blue fluorescent material and the'green fluorescent material can also be arranged on the semiconductor light emitting element 11, and used in combination with red fluorescent material layer 12.

In this embodiment, the fluorescent material layer 12 comprising the fluorescent complex and the resin is provided in a film form on the inside of the outside cap 13. However, it is also possible to employ other forms. Examples thereof include a method of providing an inorganic fluorescent material layer containing an inorganic fluorescent material on the semiconductor light emitting element 11 mounted on the upper portion of the mount lead 16b, and further laminating thereon a fluorescent material film comprising the complex-containing fluorescent material and the resin; a method of laminating a fluorescent material film on the semiconductor light emitting element 11 with the interposition of a heat insulating layer or a diffusion layer; and the like. In this case, the whole device is sealed in a cannonball form with an epoxy resin containing the ultraviolet absorbing agent without providing the outside cap 13, thereby being able to shield the fluorescent material from ultraviolet rays from outside light.

### (Second Embodiment)

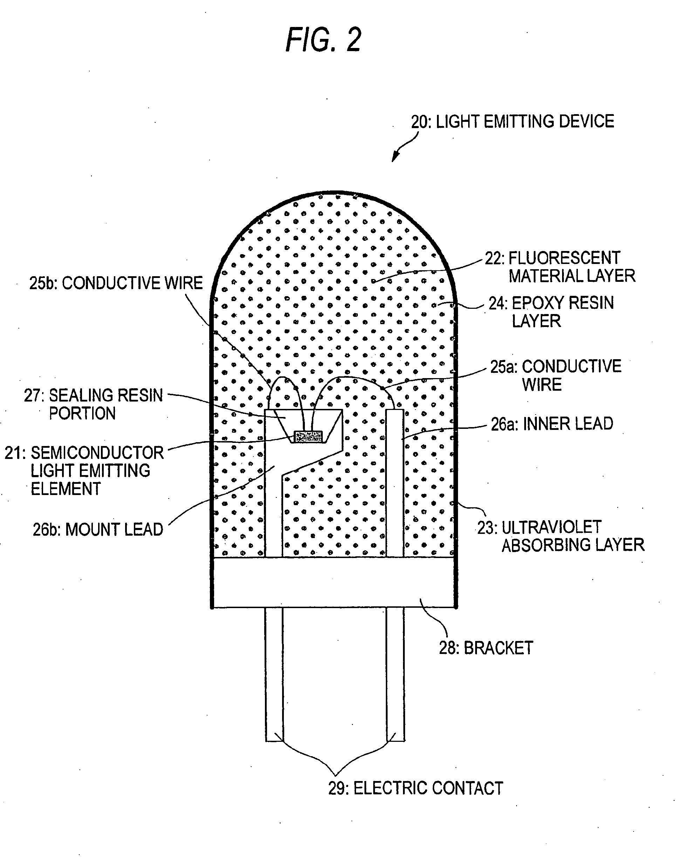

Fig. 2 is a view for illustrating the light emitting device of a second embodiment. The light emitting device 20 shown in Fig. 2 comprises a brancket 28, a mount lead 26b and an inner lead 26a which are attached to the brancket 28, an electric contact 29 which is attached to a lower portion of the brancket 28 and conductive to the mount lead 26b and the inner lead 26a, a semiconductor light emitting element 21 housed in a cup of an upper portion of the mount lead 26b, a sealing resin portion 27 such as an epoxy resin which is filled in the cup of the upper portion of the mount lead 26b to fix the semiconductor light emitting element 21, a conductive wire 25a which makes the inner lead 26a and the semiconductor light emitting element 21 conductive to each other, a conductive wire 25b which makes the semiconductor light emitting element 21 and the mount lead 26b conductive to each other, an epoxy resin portion 24 which seals these and is formed in a dome form, a fluorescent material 22 of fine particles dispersed in the epoxy resin portion 24, and an ultraviolet absorbing layer 23 which covers the outside of the epoxy resin portion 24 and contains an ultraviolet absorbing agent. The fluorescent material 22 may be dissolved in the epoxy resin portion 24.

The fluorescent material 22 is required to be shielded from ultraviolet light included in outside light by the ultraviolet absorbing layer 23 provided on the outside of the epoxy resin portion 24 to be substantially shielded from light having a wavelength of 350 nm or less. In terms of the protection of organic compounds such as a resin, it is preferred to shield ultraviolet rays of 400 nm or less. When the ultraviolet absorbing layer 23 is not provided, it is possible to shield light having a wavelength of 350 nm or less by incorporating the ultraviolet absorbing agent into the epoxy resin portion 24.

### (Third Embodiment)

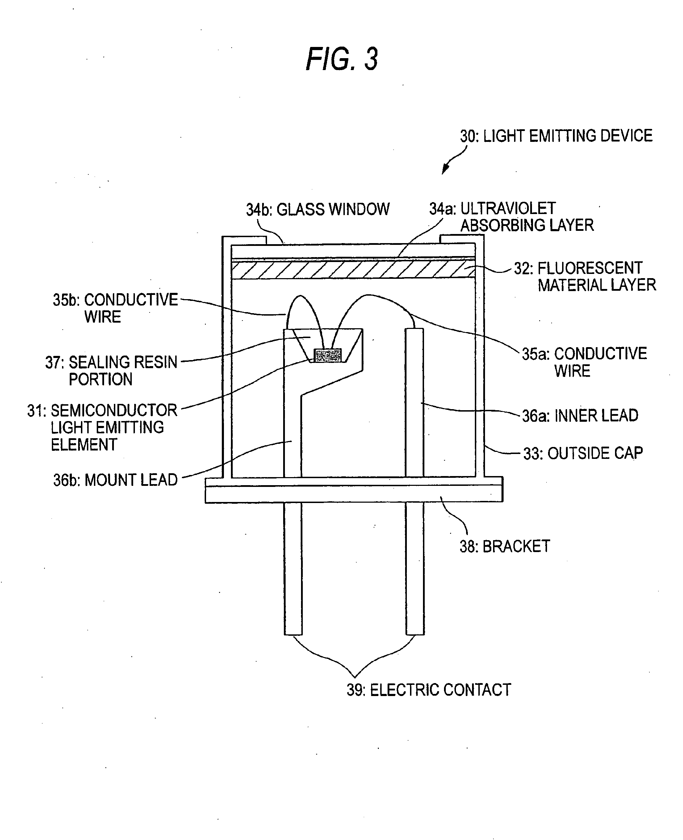

Fig. 3 is a view for illustrating the light emitting device of a third embodiment. The light emitting device 30 shown in Fig. 3 comprises a brancket 38, a mount lead 36b and an inner lead 36a which are attached to the brancket 38, an electric contact 39 which is attached to a lower portion of the brancket 38 and conductive to the mount lead 36b and the inner lead 36a, a conductive wire 35a which makes the inner lead 36a and a semiconductor light emitting element 31 conductive to each other, a conductive wire 35b which makes the semiconductor light emitting element 31 and the mount lead 36b conductive to each other, the semiconductor light emitting element 31 housed in a cup of an upper portion of the mount lead 36b, a sealing resin portion 37 such as an epoxy resin which is filled in the cup of the upper portion of the mount lead 36b to fix the semiconductor light emitting element 31, an outside cap 33 for housing these, a fluorescent material layer 32 provided on the upper portion of the outside cap 33, an ultraviolet absorbing layer 34a which is formed on the fluorescent material layer 32, and a glass window 34b. The inside of the outside cap 33 is filled with an inert gas. The fluorescent material layer 32 is shielded from light having a wavelength of 350 nm or less included in outside light by the ultraviolet absorbing layer 34a.

The light emitting devices 10 and light emitting devices 20 to which this embodiment is applied can be used singly or as a combination of the plurality thereof, for example, as various lighting systems such as a lighting lamp, a back light for a liquid crystal panel or the like and ultrathin type illumination, and display units.

### Examples

This embodiment will be illustrated in greater detail with reference to the following examples, but this embodiment should not be construed as being limited thereto. Further, all the parts and percentages in the examples are given by weight unless otherwise specified.

### Example 1

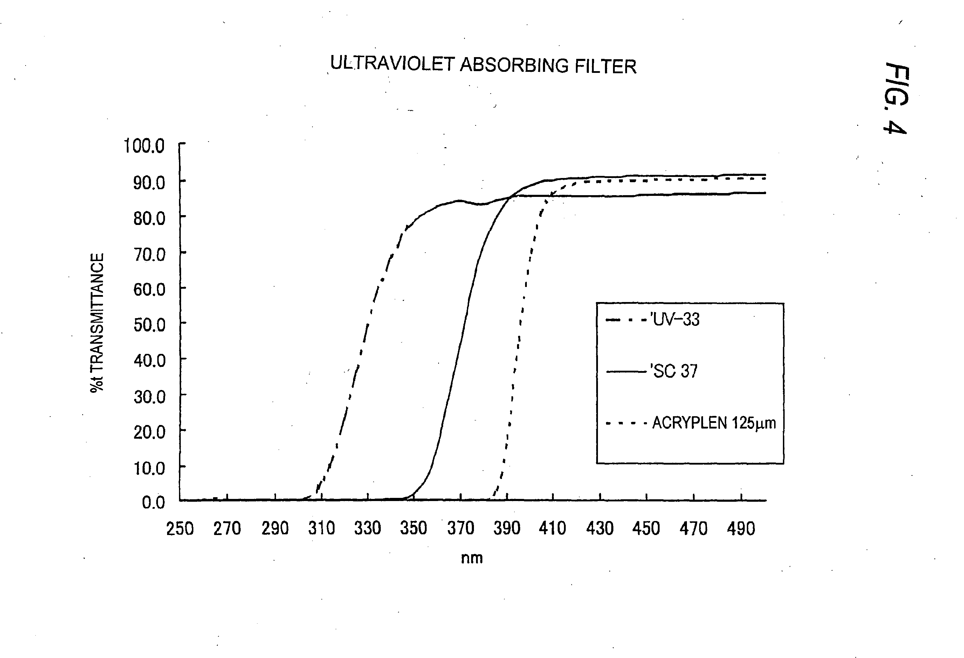

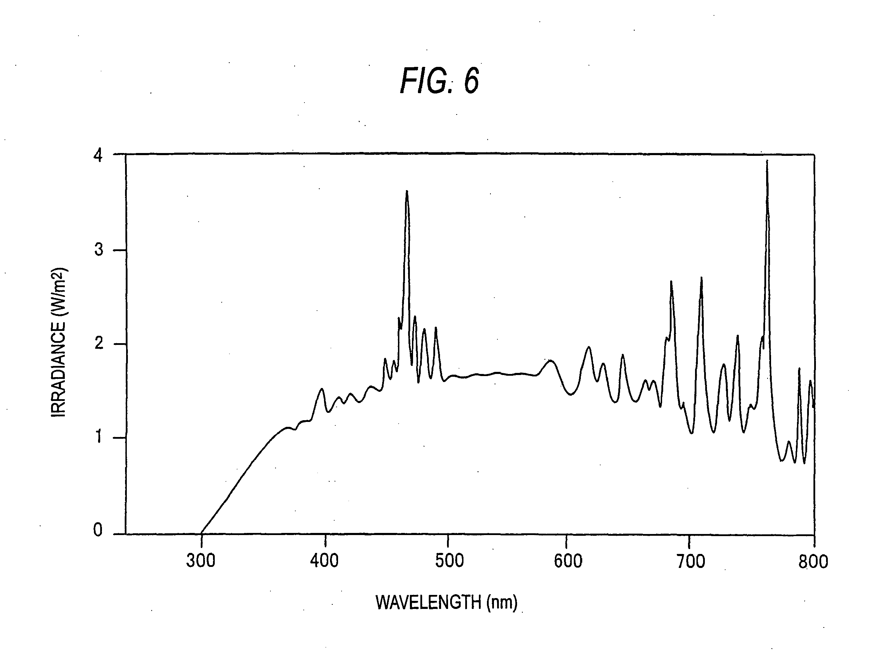

Ten parts of a europium (Eu) complex represented by the formula shown below was mixed with 200 parts of a methyl ethyl ketone solution (concentration: 20%) of polyvinyl butyral (ESUREKKU BL-1, manufactured by Sekisui Chemical Co., Ltd.) to prepare a mixed solution, and 0.2 to 0.3 g of this mixed solution was applied onto the inside of a glass ampoule having a diameter of 14 mm and dried to form a fluorescent material layer. Then, this ampoule was vacuum sealed (2.5×10⁻⁵ torr) to prepare a vacuum-sealed glass ampoule whose inside was coated with the Eu complex fluorescent material layer. The outside of this glass ampoule was covered with an ultraviolet shielding filter (Acryplen HB-S006 manufactured by Mitsubishi Rayon Co., Ltd.) having wavelength-transmittance behavior shown in Fig. 4 and a transmittance of 50% at 395 nm, and then irradiated with light from an ultraviolet region to a visible region for 120 hours, 400 hours, 1000 hours, 2500 hours, 4500 hours and 7000 hours, respectively, using a light stability tester (Ci4000 manufactured by Atlas): Then, the fluorescence intensity of the europium (Eu) complex-containing fluorescent material was measured using a Hitachi fluorescence spectrometer F4500. The results thereof are shown in Table 1. Fig. 6 shows a radiation spectrum of a light source (xenon lamp) of the light stability tester. The fluorescence intensity of the fluorescent material is indicated as an index taking as 100 the fluorescence intensity at the time when the fluorescent material is not irradiated with light by the light stability tester. The numerical value closer to 100 indicates better light stability.

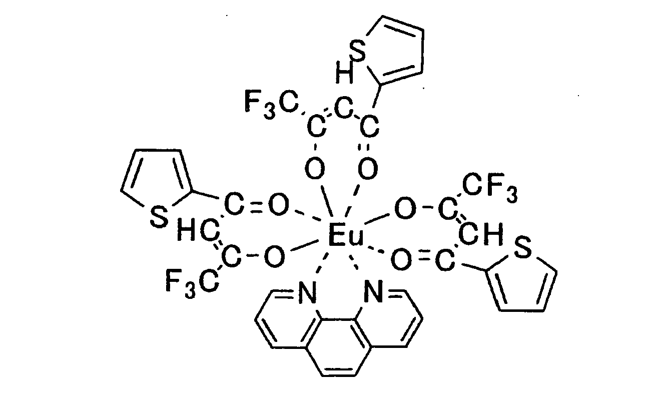

### Example 2

The light stability test was performed in the same manner as in Example 1 with the exception that an ultraviolet shielding filter having a transmittance of 50% at 370 nm and a transmittance of 2% at 350 nm (Cut Filter SC37 manufactured by Fuji Photo Film Co., Ltd.) was used. The results thereof are shown in Table 1.

### Comparative Example 1

The light stability test was performed in the same manner as in Example 1 with the exception that an ultraviolet shielding filter having a transmittance of 50% at 330 nm (Toshiba Color Glass Filter UV33) was used. The results thereof are shown in Table 1.

### Comparative Example 2

The light stability test was performed in the same manner as in Example 1 with the exception that no ultraviolet shielding filter was attached. The results thereof are shown in Table 1.

**Table 1**

| | | Example | | Comparative Example | |
|---|---|---|---|---|---|
| | | 1 | 2 | 1 | 2 |
| Ultraviolet Shielding Filter | | Acryplen | SC37 | UV33 | Not used |
| Irradiation Time | 0 | 100 | 100 | 100 | 100 |
| | 120 hours | 100 | 100 | 82 | 77 |
| | 400 hours | 106 | 102 | 73 | 63 |
| | 1000 hours | 99 | 112 | 70 | 57 |
| | 2500 hours | 107 | 104 | 34 | 22 |
| | 4500 hours | 109 | 99 | 40 | 17 |
| | 7500 hours | 114 | 103 | 31 | 6 |

The fluorescence intensity was measured using the cylindrical ampoule, so that the variation in measured data caused by the displacement of the location of measurement was about ±10%. However, the results of Table 1 reveals that when the ultraviolet shielding filter having a transmittance of 50% at 395 nm is used (Example 1) and when the ultraviolet shielding filter having a transmittance of 50% at 370 nm and a transmittance of 2% at 350 nm is used (Example 2), the results of the light stability test in which a decrease in fluorescence intensity is not observed in long-term light irradiation is obtained to show extremely good light stability.

In contrast, when the ultraviolet shielding filter having a transmittance of 50% at 330 nm is used (Comparative Example 1), in which the fluorescent material is irradiated with ultraviolet light having a short wavelength of 350 nm or less, and when no ultraviolet shielding filter is attached (Comparative Example 2), the results of the light stability test in which fluorescence intensity rapidly decreases is obtained to show extremely poor light stability.

### Example 3

A fluorescent material layer was provided on a slide glass in the same manner as in Example 1, and an epoxy resin layer was formed on an upper portion of the fluorescent material layer and cured by heat to provide a sealing layer having a thickness of 2 mm. This sealing layer was covered with an ultraviolet shielding filter ultraviolet shielding filter (SC37) having a transmittance of 50% at 370 nm and a transmittance of 2% at 350 nm, and the light stability test was performed in the same manner as in Example 1 with the exception that the irradiation time was set to 40 hours, 80 hours and 120 hours, respectively. The results thereof are shown in Table 2.

### Comparative Example 3

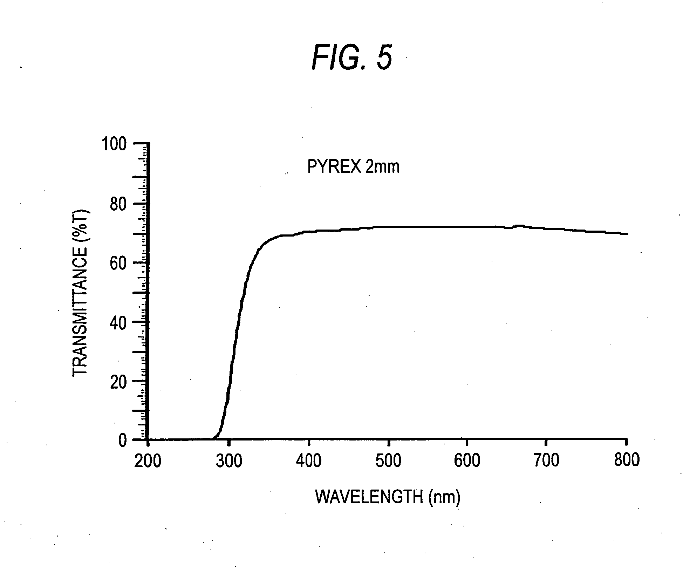

The weather resistance test was performed under the same conditions as in Example 3 with the exception that the ultraviolet shielding filter was not used on the sealing layer prepared in Example 3. Wavelength-transmittance behavior of glass (Pyrex (registered trade mark), thickness: 2 mm) is shown in Fig. 5. The results thereof are shown in Table 2.

**Table 2**

| | | Example 3 | Comparative Example 3 |
|---|---|---|---|
| Light Irradiation Time | 0 | 100 | 100 |
| | 40 hours | 103 | 90 |
| | 80 hours | 98 | 73 |
| | 120 hours | 93 | 64 |

The results of Table 2 reveals that when the ultraviolet shielding filter having a transmittance of 50% at 370 nm and a transmittance of 2% at 350 nm is used (Example 3), the results in which changes in fluorescence intensity are not observed are obtained to show extremely good light stability. In contrast, when no ultraviolet shielding filter is attached (Comparative Example 3), it is found that light stability of the fluorescent material is extremely poor.

### Example 4

A fluorescent material layer and an epoxy resin sealing layer were provided on upper portion of an LED (NSHU 550 manufactured by Nichia Corporation) having a light emission wavelength of 375 nm in the same manner as in Example 3, and light irradiation was conducted for 80 hours under the same conditions as in Example 3 using the weather resistance tester. Then, the LED was lighted, and light emission intensity of the fluorescent material was measured. As a result, the light emission intensity was approximately equal to that before light irradiation.

### Example 5

The Eu complex (I) used in Example 1, a blue fluorescent material (Sr, Ca, Ba, Mg)₁₀(PO₄)₆Cl₂:Eu and a green fluorescent material ZnS:Cu, Au, Al were mixed at a weight ratio of 3:54:43, and dissolved in an aqueous solution of polyvinyl alcohol. The dispersion was applied onto a polyester film having a thickness of 75 µm and dried to prepare a fluorescent material layer having a thickness of 20 µm. This fluorescent material layer and an ultraviolet shielding filter (SC37) were cut to such a size that it fell into a metal cap of an LED element and to a circular form. The filter and the fluorescent material layer were placed in the cap in this order so that the ultraviolet shielding filter was disposed outside. This cap was sealed to an LED bare chip having a peak wavelength of 395 nm (manufactured by Cree, Inc.) under a nitrogen atmosphere to prepare a white light LED. This was irradiated with light for 120 hours using the light stability tester, and then lighted. As a result, white light having a luminance equivalent to that before irradiation was obtained.

Although the present invention has been described in detail in its specific embodiments, it will be obvious to those skilled in the art that various changes and modifications are possible without departing from the spirit and scope of the invention.

The present application is based on Japanese Patent Application (Patent Application No. 2003-154571) filed on May 30, 2003, the whole of which is incorporated herein by reference.

### Industrial Applicability

According to the present invention, there can be provided a light emitting device which can improve durability of a fluorescent complex-containing fluorescent material and can generate high-intensity light emission.

## Claims

1. A light emitting device comprising:
a light emitter which emits light within the region from near-ultraviolet light to visible light, and
a fluorescent material containing at least one fluorescent complex which emits light by the action of light from the light emitter,
wherein the fluorescent material is irradiated with substantially no light having a wavelength of 350 nm or less.

2. The light emitting device according to claim 1, wherein said light emitter is a semiconductor light emitting element, and that said fluorescent material is irradiated with substantially no light having a wavelength of 350 nm or less by providing, between the semiconductor light emitting element and said fluorescent material, a light absorbing means which absorbs light having a wavelength of 350 nm or less or by using a semiconductor light emitting element which substantially does not emit light of 350 nm or less.

3. The light emitting device according to claim 2, wherein said semiconductor light emitting element is a semiconductor light emitting element which emits light having a peak wavelength within the range of 360 nm to 470 nm.

4. The light emitting device according to claim 1, wherein said fluorescent material is irradiated with substantially no light having a wavelength of 350 nm or less by providing, between said light emitter and said fluorescent material, a light absorbing means which absorbs light having a wavelength of 350 nm or less.

5. The light emitting device according to claim 4, wherein said light emitter is a discharge lamp.

6. The light emitting device according to any one of claims 1 to 5, wherein said fluorescent material is irradiated with substantially no light having a wavelength of 350 nm or less by providing an ultraviolet absorbing layer on an outside of said fluorescent material.

7. The light emitting device according to any one of claims 1 to 6, wherein said fluorescent material is placed under vacuum or under an atmosphere of inert gas.

8. The light emitting device according to any one of claims 1 to 6, wherein said light emitter and said fluorescent material are sealed with a resin.

9. The light emitting device according to any one of claims 1 to 8, wherein said fluorescent complex is a rare earth ion complex.

10. The light emitting device according to claim 9, wherein said rare earth ion complex is a rare earth ion complex having as a ligand an anion which is derived from a β-diketone having an aromatic ring-containing substituent group or from a carboxylic acid having an aromatic ring-containing substituent group.

11. The light emitting device according to claim 9 or 10, wherein said rare earth ion complex has a Lewis base as an auxiliary ligand.

12. The light emitting device according to any one of claims 9 to 11, wherein said rare earth ion complex is a europium complex.

13. The light emitting device according to any one of claims 1 to 12, wherein said fluorescent material comprises a red fluorescent material containing a fluorescent complex, a blue fluorescent material and a green fluorescent material.

14. A light emitting device comprising:
(a-1) a light-permeable container having therein a light emitter which emits light within the region from near-ultraviolet light to visible light, and a fluorescent material containing at least one fluorescent complex which emits light by the action of light from said light emitter, or (a-2) a resin-sealed body having therein a light emitter which emits light within the region from near-ultraviolet light to visible light, and a fluorescent material containing at least one fluorescent complex which emits light by the action of light from said light emitter; and
(b) an ultraviolet shielding means which shields said fluorescent material from ultraviolet rays.

15. The light emitting device according to claim 14, wherein said ultraviolet shielding means is an ultraviolet absorbing layer provided on an outside or inside of said container, or on an outside of said resin-sealed body.

16. The light emitting device according to claim 15, wherein said ultraviolet absorbing layer is a resin layer having incorporated therein an ultraviolet absorbing agent.

17. The light emitting device according to any one of claims 14 to 16, wherein said ultraviolet shielding means is said container or resin-sealed body formed from a light-permeable material containing an ultraviolet absorbing agent.

18. The light emitting device according to claim 16 or 17, wherein said ultraviolet absorbing layer is one in which one kind or two or more kinds of ultraviolet absorbing agents for absorbing light having a wavelength of 400 nm or less are incorporated.

19. The light emitting device according to any one of claims 14 to 18, wherein a light absorbing means which absorbs light having a wavelength of 350 nm or less is further provided between said light emitter and said fluorescent material.

20. The light emitting device according to any one of claims 1 to 19, wherein the light emitting device is a lighting system.
